# FASCICULE DE BREVET EUROPEEN

(11) **EP 0 923 438 B1**
(45) Date de publication et mention de la délivrance du brevet: **21.01.2004**
(21) Numéro de dépôt: 97938950.9
(22) Date de dépôt: 26.08.1997
(51) Int. Cl.: B28D 5/00

(54) **PROCEDE D'OBTENTION D'UNE PLAQUETTE DE MATERIAU SEMICONDUCTEUR DE GRANDES DIMENSIONS**
VERFAHREN ZUR HERSTELLUNG VON HALBLEITERSCHEIBEN GROSSER ABMESSUNGEN
METHOD FOR OBTAINING A WAFER IN SEMICONDUCTING MATERIAL OF LARGE DIMENSIONS

(30) Priorité: 27.08.1996 FR 9610482
(43) Date de publication de la demande: 23.06.1999
(73) Titulaire: COMMISSARIAT A L'ENERGIE ATOMIQUE, 75015 Paris (FR)
(72) Inventeur: BRUEL, Michel, F-38113 Veurey (FR)
(74) Mandataire: Audier, Philippe André
(86) Numéro de dépôt international: PCT/FR1997/001526
(87) Numéro de publication internationale: WO 1998/008664

(56) Documents cités:
- FR-A- 2 681 472
- US-A- 2 355 877
- PATENT ABSTRACTS OF JAPAN vol. 96, no. 10, 31 octobre 1996 & JP 08 143397 A (NIPPON STEEL CORP), 4 juin 1996,

## Description

La présente invention concerne un procédé d'obtention d'une plaquette de matériau semiconducteur de grandes dimensions. Elle concerne également l'utilisation de la plaquette obtenue pour réaliser des substrats de type semiconducteur sur isolant, et en particulier de type silicium sur isolant.

On connaît plusieurs procédés de réalisation d'un substrat constitué d'une couche ou d'un film de matériau semiconducteur sur un support isolant. Ces procédés permettent d'obtenir en particulier des substrats du type silicium sur isolant.

Les méthodes d'hétéroépitaxie permettent par croissance cristalline de faire croître un cristal par exemple en silicium en film mince sur un substrat monocristallin d'une autre nature dont le paramètre de maille est voisin de celui du silicium, par exemple : substrat de saphir (Al₂O₃) ou de fluorure de calcium (CaF₂).

Le procédé SIMOX utilise l'implantation ionique à forte dose d'oxygène sans un substrat de silicium pour créer dans le volume du silicium une couche d'oxyde de silicium séparant un film mince de silicium monocristallin de la masse de substrat.

D'autres procédés utilisent le principe de l'amincissement d'une plaquette par abrasion mécanochimique ou chimique. Les procédés de cette catégorie les plus performants utilisent en outre le principe de la barrière d'arrêt à la gravure qui permet d'arrêter l'amincissement de la plaquette dès que l'épaisseur requise est atteinte et donc de garantir une homogénéité d'épaisseur. Cette technique consiste par exemple à doper de type p le substrat de type n sur l'épaisseur du film que l'on désire obtenir et à attaquer chimiquement le substrat avec un bain chimique actif pour le silicium de type n et inactif par le silicium de type p.

Les principales applications des films minces de semiconducteur sont les substrats Silicium Sur Isolant, les membranes autoporteuses de silicium ou de carbure de silicium pour réaliser des masques pour lithographie par rayons X, les capteurs, les cellules solaires, la fabrication de circuits intégrés à plusieurs couches actives.

Les diverses méthodes de réalisation des films minces présentent des inconvénients liés aux techniques de fabrication.

Les méthodes d'hétéroépitaxie sont limitées par la nature du substrat. Le paramètre de maille du substrat n'étant pas strictement exact à celui du semiconducteur, le film mince comporte beaucoup de défauts cristallins. En outre ces substrats sont chers et fragiles et n'existent qu'en dimension limitée.

La méthode SIMOX requiert une implantation ionique à très forte dose ce qui nécessite une machine d'implantation très lourde et complexe. Le débit de ces machines est faible et il est difficilement envisageable de l'augmenter dans des proportions notables.

Les méthodes d'amincissement ne sont compétitives du point de vue de l'homogénéité et de la qualité que si elles utilisent le principe de la barrière d'arrêt à la gravure. Malheureusement, la création de cette barrière d'arrêt rend le procédé complexe et peut limiter dans certains cas l'utilisation du film. En effet, si l'arrêt de la gravure est réalisé par dopage de type p dans un substrat de type n, la réalisation éventuelle de dispositifs électroniques dans le film devra s'accommoder de la nature de type p du film.

Un procédé plus récent a été mis au point pour remédier aux inconvénients de ces techniques antérieures. Ce procédé, décrit dans le document FR-A-2 681 472, consiste à soumettre une plaquette du matériau semiconducteur désiré et comportant une face plane aux étapes suivantes :
- une première étape d'implantation par bombardement de la face plane de la plaquette au moyen d'ions créant, dans le volume de la plaquette et à une profondeur voisine de la profondeur de pénétration des ions, une couche de microcavités séparant la plaquette en une région inférieure constituant la masse du substrat et une région supérieure constituant le film mince, les ions étant choisis parmi les ions de gaz rares ou de gaz hydrogène et la température de la plaquette étant maintenue au-dessous de la température à laquelle les ions implantés peuvent s'échapper du semiconducteur par diffusion ;
- une deuxième étape éventuelle de mise en contact intime de la face plane de la plaquette avec un support (raidisseur) constitué au moins d'une couche de matériau rigide, ce contact intime pouvant être réalisé par exemple à l'aide d'une substance adhésive ou par l'effet d'une préparation préalable des surfaces et éventuellement d'un traitement thermique ou/et électrostatique pour favoriser les liaisons interatomiques entre le support et la plaquette ;
- une troisième étape de traitement thermique de l'ensemble plaquette et support à une température supérieure à la température durant laquelle l'implantation a été effectuée et suffisante pour créer par effet de réarrangement cristallin dans la plaquette et de pression des microcavités une séparation entre le film mince et la masse du substrat (cette température est par exemple de 500°C pour du silicium).

Ce procédé semble très prometteur. Il permet, par exemple, d'obtenir des substrats Silicium Sur Isolant (SSI) à partir de plaquettes de silicium monocristallin. Pour les applications de la microélectronique, le matériau semiconducteur doit être de qualité électronique. Dans le cas du silicium, on obtient, industriellement, des plaquettes de cette qualité à partir de deux méthodes de croissance : la méthode Czochralski de tirage à partir d'un bain de silicium fondu (CZ) et la méthode de fusion de zone à partir d'un lingot polycristallin (FZ), la première méthode étant la plus utilisée. Ces méthodes de croissance fournissent des lingots de forme cylindrique et qui sont découpés en tranches perpendiculaires à l'axe du cylindre, généralement à l'aide d'une scie circulaire à coupe interne.

L'homme du métier du domaine de la microélectronique qui veut mettre en oeuvre le procédé décrit dans le document FR-A-2 681 472 utilisera donc comme source de matériau semiconducteur une plaquette taillée dans une tranche d'un lingot semiconducteur. S'il désire obtenir un substrat SSI de grandes dimensions, il taillera sa plaquette en conséquence dans la tranche. Actuellement, on sait faire des lingots de 300 mm de diamètre et cette dimension impose donc les limites dimensionnelles du substrat SSI.

Il est cependant des cas où des substrats SSI de dimensions supérieures au diamètre des plus gros lingots sont désirés. C'est le cas par exemple des applications silicum sur verre, notamment pour réaliser des écrans de visualisation du type LCD/TFT. Ces écrans sont de forme rectangulaire et par exemple au format 16/9. Un écran de ce format et de hauteur 300 mm aura donc une longueur d'environ 533 mm. Un tel écran ne peut donc pas être conçu à partir d'une plaquette de 300 mm de diamètre.

D'autres applications requièrent également. des substrats de dimensions comparables : films minces de silicium autoporteurs, photopiles.

Il n'est donc pas possible de concevoir de tels dispositifs, de grandes dimensions, à partir d'une plaquette circulaire classique constituée par une tranche d'un lingot semiconducteur.

Le document Patent Abstracts of Japan, vol. 96, N° 10, 31 octobre 1996, relatif à la demande de brevet JP-A-08 143 397 divulgue un procédé d'obtention de plaquettes de SiC monocristallin par découpe d'un lingot du même matériau. La découpe est effectuée selon un plan longitudinal du lingot, ce plan étant parallèle à un plan cristallographique présenté par le lingot.

Pour remédier à l'inconvénient présenté par les dimensions insuffisantes des plaquettes circulaires classiques, il est donc proposé selon la présente invention de découper le lingot cylindrique en tranches non plus perpendiculaires à l'axe du cylindre, mais en tranches longitudinales et notamment en tranches parallèles à l'axe du cylindre, le lingot étant choisi de façon que son diamètre soit au moins égal à la largeur de la plaquette désirée, et que sa longueur soit au moins égale à la longueur de la plaquette désirée.

Cette manière de découper le lingot de matériau semiconducteur va à l'encontre de toutes les habitudes prises aussi bien par l'utilisateur de plaquettes semiconductrices que par le fabricant de plaquettes. L'utilisateur en effet achète ses plaquettes au fabricant en fonction des tailles disponibles. Quant au fabricant, il ne lui vient pas naturellement à l'esprit de découper les lingots de matériau semiconducteur autrement que de manière conventionnelle, notamment parce que tout son matériel est prévu pour cela.

L'abrégé du document JP-A-08 143 397 ne divulgue pas, qu'après la découpe d'une plaquette, une épitaxie peut être effectuée pour reconstituer l'épaisseur de la plaquette découpée.

L'invention à donc pour objet un procédé d'obtention d'au moins une plaquette de matériau semiconducteur par découpe dans un lingot de matériau semiconducteur, la découpe étant effectuée selon un plan longitudinal du lingot, ce plan étant parallèle ou sensiblement parallèle à un plan cristallographique présenté, le cas échéant, par le lingot de matériau semiconducteur, caractérisé en ce qu'après la découpe du lingot on effectue une épitaxie pour reconstituer tout ou partie de l'épaisseur de la plaquette découpée.

Par plan longitudinal du lingot on entend un plan qui n'est pas forcément parallèle à l'axe de plus grande dimension du lingot. Il peut s'agir d'un plan incliné par rapport à l'axe de plus grande dimension du lingot pour respecter par exemple un plan cristallographique particulier d'un matériau semiconducteur monocristallin, le principe de l'invention étant de permettre l'obtention de plaquettes de surface supérieure à la surface d'une plaquette obtenue par une découpe perpendiculaire à l'axe de plus grande dimension du lingot.

La découpe peut avantageusement être effectuée selon un plan parallèle ou sensiblement parallèle à un plan cristallographique présenté, le cas échéant, par le lingot de silicium. En effet, un autre aspect original de l'invention, le cas échéant, par le lingot de réside, non seulement dans le fait d'avoir pensé à découper longitudinalement un lingot, mais aussi que cette découpe permet également d'obtenir des substrats orientés cristallographiquement.

Cependant, dans sa généralité, l'invention s'applique à des lingots de matériaux semiconducreurs quelconques (monocristallin, polycriscallin, amorphe).

Le procédé selon l'invention concerne en particulier le cas où le lingot est un lingot de silicium obtenu par tirage CZ ou FZ. Dans ce cas, le lingot peut avoir été obtenu par un tirage qui donne un plan de type <1,0,0> perpendiculaire à l'axe du lingot.

La découpe du lingot peut avantageusement se faire de deux façons. Elle peut être faite de façon à débiter le lingot en plaquettes parallèles entre elles. Elle peut aussi être faite de façon à débiter le lingot en deux groupes de plaquettes, les plaquettes d'un même groupe étant parallèles entre elles et étant perpendiculaires aux plaquettes de l'autre groupe.

Une plaquette ainsi obtenue peut être utilisée avantageusement pour réaliser un substrat du type semiconducteur sur isolant, en particulier un substrat de grandes dimensions. Il est alors particulièrement intéressant d'obtenir ce substrat par le procédé décrit dans le document FR-A-2 681 472 et en utilisant un support comportant au moins une partie isolante.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 représente un lingot de silicium monocristallin auquel on a associé des plans cristallographiques,
- la figure 2 illustre une première façon de découper un lingot de matériau semiconducteur, selon l'invention,
- la figure 3 illustre une deuxième façon de découper un lingot de matériau semiconducteur, selon l'invention.

Dans la suite de la description, le lingot de matériau semiconducteur décrit est un lingot de silicium monocristallin et la plaquette désirée est une plaquette de forme rectangulaire. Ce matériau a été choisi car il est, de loin, le matériau le plus utilisé dans le domaine de la microélectronique. Cependant, l'invention ne se limite pas à ce type de matériau.

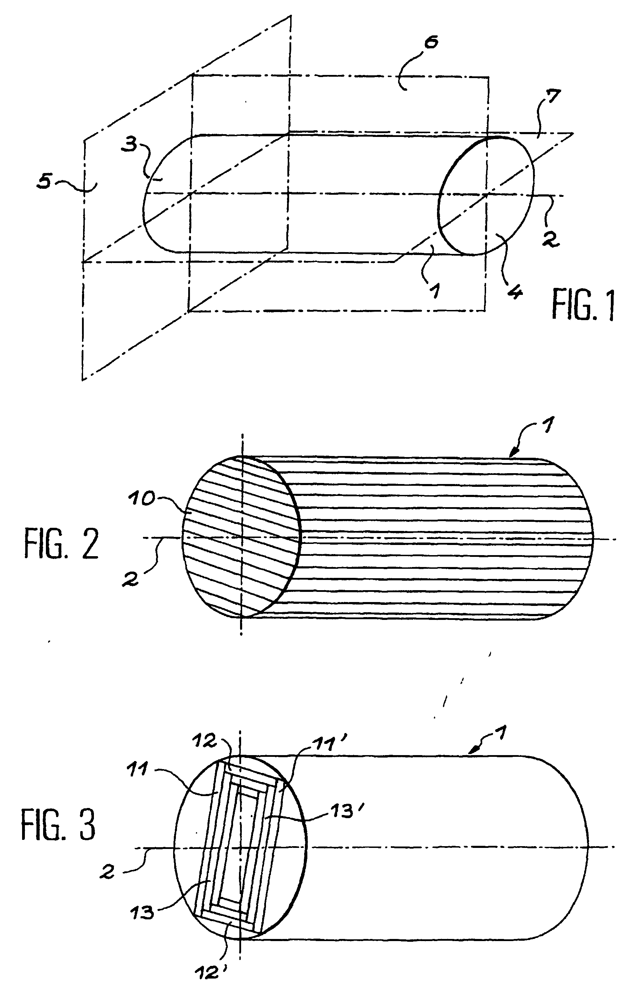

La figure 1 montre un lingot 1 de silicium monocristallin obtenu par tirage CZ ou FZ. Il a approximativement la forme d'un cylindre de révolution d'axe 2. Pour ce lingot cylindrique, on peut définir deux bases 3 et 4 perpendiculaires à l'axe 2. Le tirage a été choisi pour obtenir un lingot orienté selon le plan cristallographique <1,0,0>, plan portant la référence 5 sur la figure 1. Dans ce cas, il existe deux autres plans de type <1,0,0>, les plans <0,0,1> et <0,1,0> référencés 6 et 7, parallèles à l'axe 2 du lingot.

L'objectif de l'invention étant d'obtenir au moins une plaquette de grande dimension, le diamètre du lingot est au moins égal à la largeur de la surface rectangulaire de la plaquette et son tirage est tel que la longueur du lingot est au moins égal à la longueur de la surface rectangulaire de la plaquette à obtenir.

La figure 2 montre une première façon de découper le lingot 1 tel qu'illustré par la figure 1. La découpe est dans ce cas effectuée de façon à avoir des plaquettes parallèles entre elles et parallèles à l'un des plans <1,0,0> référencés 6 et 7 sur la figure 1. on obtient des plaquettes, telles que la plaquette 10, qui ont toutes la même longueur mais des largeurs différentes. De préférence, la découpe sera effectuée au moyen d'une scie à fil.

La figure 3 montre une deuxième façon de découper le lingot 1 tel qu'illustré par la figure 1. La découpe peut être effectuée en faisant tourner périodiquement le lingot de 90° autour de son axe principal 2. Ainsi, après avoir par exemple découpé deux plaquettes 11 et 11', le lingot sera tourné de 90° et on découpera deux plaquettes 12 et 12' puis, après une rotation de 90°, deux plaquettes 13 et 13', etc. La découpe est également effectuée de préférence avec une scie à fil.

Les plaquettes obtenues peuvent subir ensuite tous les traitements thermiques utilisés en microélectronique et en particulier un traitement classique de polissage permettant de leur conférer une qualité de surface microélectronique.

Le procédé d'obtention d'un substrat Silicium Sur Isolant décrit dans le document FR-A-2 681 472 peut alors être mis en oeuvre en prenant une plaquette ainsi obtenue comme source de silicium.

Chaque plaquette de silicium monocristallin ainsi fabriquée peut servir à réaliser un certain nombre de substrats SSI (par exemple silicium-sur-verre). En effet, l'épaisseur des plaquettes obtenues est de l'ordre du mm ou de quelques mm et l'épaisseur de silicium transférée sur le support isolant est de l'ordre du micromètre. Après l'application du procédé de transfert du silicium selon FR-A-2 681 472 (éventuellement sans raidisseur), il suffit de repolir la plaquette pour l'utiliser à nouveau. On peut également prévoir, après avoir appliqué le procédé de transfert de silicium, de repolir la surface de la plaquette et de lui faire subir une épitaxie silicium sur silicium pour reconstituer l'épaisseur initiale.

## Revendications

1. Procédé d'obtention d'au moins une plaquette de matériau semiconducteur par découpe dans un lingot de matériau semiconducteur (1), la découpe étant effectuée selon un plan longitudinal du lingot, ce plan étant parallèle ou sensiblement parallèle à un plan cristallographique présenté, le cas échéant, par le lingot de matériau semiconducteur, **caractérisé en ce qu'**après la découpe du lingot on effectue une épitaxie pour reconstituer tout ou partie de l'épaisseur de la plaquette découpée.

2. Procédé selon la revendication 1, **caractérisé en ce que** la découpe consiste à débiter le lingot (1) en plaquettes (10) parallèles entre elles.

3. Procédé selon la revendication 1, **caractérisé en ce que** la découpe consiste à débiter le lingot (1) en deux groupes de plaquettes, les plaquettes (11, 11', 13, 13') d'un même groupe étant parallèles entre elles et étant perpendiculaires aux plaquettes (12, 12') de l'autre groupe.

4. Procédé selon la revendication 3, **caractérisé en ce que**, après découpe de deux plaquettes d'un même groupe, on procède à la découpe de deux plaquettes de l'autre groupe et enfin à l'épitaxie du lingot ainsi découpé.

5. Procédé selon l'une quelconque des revendications 1 à 4, **caractérisé en ce que** la plaquette découpée est traitée pour réaliser plusieurs substrats.

6. Procédé selon la revendication 5, **caractérisé en ce que** la réalisation desdits substrats implique un transfert de couches de matériau semiconducteur de la plaquette découpée, chaque couche de matériau semiconducteur étant obtenue par fracture au niveau d'une zone fragilisée délimitant ladite couche dans la plaquette découpée.

7. Procédé selon la revendication 6, **caractérisé en ce que** la zone fragilisée est obtenue par implantation.

8. Procédé selon l'une quelconque des revendications 5 à 7, **caractérisé en ce que** la plaquette traitée est épitaxiée pour reconstituer tout ou partie de l'épaisseur de la plaquette découpée.

## Patentansprüche

1. Verfahren zur Herstellung von wenigstens einer Halbleiterscheibe durch das Zerschneiden eines Blocks aus Halbleitermaterial (1), wobei das Zerschneiden entsprechend einer Längsebene des Blocks erfolgt und diese Ebene parallel oder im Wesentlichen parallel zu einer kristallographischen Ebene ist, die der Halbleitermaterialblock gegebenenfalls aufweist,
**dadurch gekennzeichnet,**
**dass** man nach dem Zerschneiden des Blocks eine Epitaxie durchführt, um die Dicke der abgeschnittenen Scheibe ganz oder teilweise wieder herzustellen bzw. neu zu bilden.

2. Verfahren nach Anspruch 1, **dadurch gekennzeichnet, dass** das Zerschneiden darin besteht, den Block (1) in zueinander parallele Scheiben (10) zu zersägen.

3. Verfahren nach Anspruch 1, **dadurch gekennzeichnet, dass** das Zerschneiden darin besteht, den Block (1) in zwei Gruppen von Scheiben zu zersägen, wobei die Scheiben (11, 11', 13, 13') einer selben Gruppe parallel zueinander und senkrecht zu den Scheiben (12, 12') der anderen Gruppe sind.

4. Verfahren nach Anspruch 3, **dadurch gekennzeichnet, dass** man nach dem Abschneiden von zwei Scheiben einer selben Gruppe das Abschneiden von zwei Scheiben der anderen Gruppe und schließlich die Expitaxie des so zerschnittenen Blocks durchführt.

5. Verfahren nach einem der Ansprüche 1 bis 4, **dadurch gekennzeichnet, dass** die abgeschnittene Scheibe behandelt wird, um mehrere Substrate zu realisieren.

6. Verfahren nach Anspruch 5, **dadurch gekennzeichnet, dass** die Realisierung der genannten Substrate einen Transfer von Schichten aus Halbleitermaterial von der abgeschnittenen Scheibe umfasst, wobei man jede Halbleitermaterialschicht durch Brechen in Höhe einer brüchigen Zone erhält, welche die genannte Schicht in der abgeschnittenen Scheibe abgrenzt.

7. Verfahren nach Anspruch 6, **dadurch gekennzeichnet, dass** man die brüchige Zone durch Implantation erhält.

8. Verfahren nach einem der Ansprüche 5 bis 7, **dadurch gekennzeichnet, dass** die behandelte Scheibe einer Epitaxie unterzogen wird, um die Dicke der abgeschnittenen Scheibe ganz oder teilweise neu zu bilden bzw. wieder herzustellen.

## Claims

1. Process for obtaining at least one semiconductor material wafer by cutting a semiconductor material ingot (1), cutting taking place in accordance with a longitudinal plane of the ingot, said plane being parallel or substantially parallel to a crystallographic plane of, where appropriate, the semiconductor material ingot, **characterized in that** following the cutting of the ingot epitaxy takes place for reconstituting all or part of the thickness of the cut wafer.

2. Process according to claim 1, **characterized in that** the cut consists of cutting the ingot (1) into wafers (10) parallel to each other.

3. Process according to claim 1, **characterized in that** the cut consists of cutting the ingot (1) into two groups of wafers, the wafers (11, 11', 13, 13') in one group being parallel to each other and perpendicular to the wafers (12, 12') in the other group.

4. Process according to claim 3, **characterized in that** after cutting two wafers in the same group, cutting takes place of two wafers of the other group, followed by the epitaxy of the thus cut ingot.

5. Process according to any one of the claims 1 to 4, **characterized in that** the cut wafer is treated for producing several substrates.

6. Process according to claim 5, **characterized in that** the production of said substrates involves a transfer of layers of semiconductor material of the cut wafer, each semiconductor material layer being obtained by fracture level with an embrittled zone defining said layer in the cut wafer.

7. Process according to claim 6, **characterized in that** the embrittled zone is obtained by implantation.

8. Process according to any one of the claims 5 to 7, **characterized in that** the treated wafer is epitaxied in order to reconstitute all or part of the thickness of the cut wafer.
